Europäisches Patentamt

European Patent Office

Office européen des brevets

(19)

(11) Publication number: **0 164 710 B1**

# EUROPEAN PATENT SPECIFICATION

(12)

(45) Date of publication of patent specification: **29.05.91**    (51) Int. Cl.⁵: **G01R 19/00, H03L 7/00**

(21) Application number: **85107100.1**

(22) Date of filing: **08.06.85**

(54) Method for phase locked sampling during measurement of a periodic quantity and device for carrying out the method.

(30) Priority: **15.06.84 SE 8403225**

(43) Date of publication of application:
**18.12.85 Bulletin 85/51**

(45) Publication of the grant of the patent:
**29.05.91 Bulletin 91/22**

(84) Designated Contracting States:
**CH DE FR GB IT LI SE**

(56) References cited:
**US-A- 3 864 639**
**US-A- 4 363 099**

(73) Proprietor: **ASEA AB**

**S-721 83 Västeras(SE)**

(72) Inventor: **Brandt, Nils**
**Billstabagen 15**
**S-722 40 Västeras(SE)**
Inventor: **Karlsson, Anders, Dipl.-Ing.**
**Morkullegatan 60**
**S-724 69 Västeras(SE)**

(74) Representative: **Boecker, Joachim, Dr.-Ing.**
**Rathenauplatz 2-8**
**W-6000 Frankfurt a.M. 1(DE)**

## Description

The invention relates to a method for phase locked sampling during measurement of a periodic quantity according to the precharacterising part of claim 1. The invention also relates to a device for carrying out the method.

During sampling measurement of periodic signals, it is often desirable to be able to perform the measurement in a phase locked manner. When the frequency of the periodic signal varies, as for example the frequency of the network, it may be difficult to fulfill the demand for phase locking, which may result in problems with incorrect measurement and accuracy.

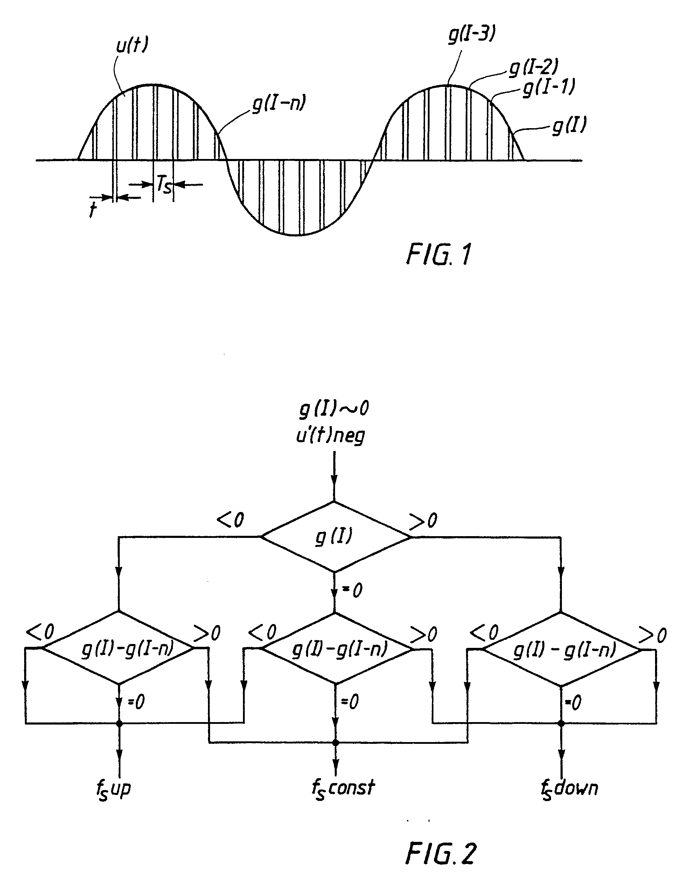

Measuring a quantity u(t) by sampling technique means that, at certain time intervals $T_s$ (sampling period) during a short period t, a measurement is made of the instantaneous value of the quantity (see Figure 1). The sampling period $T_s$ defines the sampling frequency $fs = 1/T_s$.

The measured sampled values can be obtained in analog or digital form. To get an idea of the variations, mean value, R.M.S. value, or the like, of u(t), some form of filtering or processing is needed. In the digital case there are also often carried out calculations and logical operations of different kinds during the non-measuring section $T_s$-t of the sampling period $T_s$.

The choice of the sampling frequency is determined by factors such as how long a filtering and calculating time is needed, how fast the measured signal may be expected to change its value, what accuracy is desired, etc.

Sampling frequency and measurement time are controlled by a frequency obtained by reduction of an oscillator frequency. This oscillator may, for example, be the clock oscillator of a computer. Sometimes very high demands are placed on the sampling frequency, for example if a sampling measurement is to be carried out on a periodic quantity with the demand always to make a periodically recurrent measurement in one and the same phase position. For such a measurement to take place the sampling frequency has to be such that it constitutes a certain integral multiple of the frequency $f_m$ of the quantity to be measured.

If $f_s$ is constant, an accurate synchronization for a long period of time is impossible to achieve, due to lacking stability of the frequency $f_m$.

The prior art for obtaining phase locking is normally based on zero detection of the quantity to be measured, that is, it is found out when the period starts or ends. The sampling is then initiated by the zero detection. This method is, however, not particularly satisfactory, primarily due to time constants and other inertia in these systems.

The invention aims at developing a method of the above-mentioned kind by which the sampling frequency is adapted to the frequency $f_m$ of the periodic signal so that phase locking can be maintained even if the frequency $f_m$ of the periodic signal is liable to variations. The invention also aims at developing a device for carrying out the method.

In order to achieve this aim the invention suggests a method according to the introductory part of claim 1, which is characterized by the steps of the characterizing part of claim 1.

Further developments of said method are characterized by the steps of the claims 2 and 3.

A device for carrying out the method is characterized by the features of claim 4.

The invention consists of a method of automatically adjusting the sampling frequency and the phase position of the sampling measurement moments t relative to the periodic quantity u(t) according to the variations of the frequency of said quantity u(t), thus obtaining phase locking. This is achieved by controlling or influencing the sampling period, which means that the sampling frequency is continuously adapted to an integral multiple of the frequency of the periodic quantity u(t). It should be pointed out that in addition to sinusoidal signals, the method is also applicable to other types of periodic signals.

The invention will be described in greater detail with reference to the accompanying drawings, wherein

| | |
|---|---|
| Figure 1 | shows a periodic quantity u(t) with the frequency $f_m$. The figure illustrates at what times or phase positions a sampled measurement with the sampling period $T_s$ and the measurement time t can be carried out; |
| Figure 2 | is a flow chart showing the function of the method according to the invention; |
| Figures 3.1 to 3.9 | illustrate a sampling measurement on a sinusoidal signal in accordance with the alternatives illustrated in the flow chart according to Figure 2 and table 1; |
| Figure 4 | shows an embodiment of a device for carrying out the method according to the invention. |

A method according to the invention presupposes access to a certain memory capacity, which can be rapidly read and updated, and that certain calculations as well as logical and comparative operations can be carried out.

Memories, units for calculation and other processing, such as comparison etc., can be carried out, as mentioned, in analog, digital, or hybrid technique. However, the following description will be based on digital technique, since a preferred embodiment of a device for carrying out the method is, with the present state of the art, of course, based on digital technique, for example on microprocessors.

The sampled and stored values thus are procured in digital form and are designated g(I), g(I-1), ...,g(I-n). By a certain process, which will be described below, the value of a sample at the end of a period of the periodic quantity to be measured, that is g(I), and the value of a sample at the end of the preceding period of said quantity, that is g(I-n), are found out in order to be subjected later on to special processing, which forms the basis of this invention.

The method for finding a sample located at one end of a period can be carried out as follows: Let it be assumed that it is desired to find a sample g(I) in the vicinity of a zero passage for u(t) when u(t) has a negative rate of change. By continuously following up the difference between two consecutive sampled values, it is possible to find the sample where the rate of change of u(t) changes from having a positive to having a negative value. In this way, information is given that the next sample will be measured on that flank of u(t) which has a negative rate of change. This means that u(t) after a period of time, normally corresponding to a quarter of a period of u(t), shall have zero passage from a positive to a negative value. With knowledge of the desired quotient $f_s/f_m$, that sample which arrives about a quarter of a period of u(t) later can be predicted, which corresponds to the time when u(t) has its first zero passage. This value is now defined as g(I), whereby also the value of g(I-n), that is, the value of the sample which has been obtained during the preceding zero passage when u(t) had a negative rate of change, is defined.

The method according to the invention comprises, on the one hand, finding out whether $g(I) \gtrless 0$ and, on the other hand, forming the difference between the values of g(I) and g(I-n) and comparing this difference and g(I). Depending on the result of this comparison, the sampling frequency is influenced in such a way that phase locking of the measurement at a zero passage can be achieved and maintained. The comparisons to be made and the measures to be taken are clear from the flow chart illustrated in Figure 2.

Briefly, and expressed in Boolean algebra, if measurement is performed over a whole period of u(t) and a negative rate of change for u(t) is the starting-point, the sampling period (time between the samples) shall be increased if:

$$[g(I) > 0]^{\bullet}[g(I) - g(I-n) \geqq 0] + [g(I) = 0]^{\bullet}[g(I) - g(I-n) > 0]$$

The sampling period shall be reduced if

$$[g(I) > 0]^{\bullet}[g(I) - g(I-n) \leqq 0] + [g(I) = 0]^{\bullet}[g(I) - g(I-n) < 0]$$

and no measures concerning the sampling period between the samples need be taken if

$$[g(I) = 0]^{\bullet}[g(I) - g(I-n) = 0] + [g(I) > 0]^{\bullet}[g(I) - g(I-n) < 0] + [g(I) < 0]^{\bullet}[g(I) - g(I-n) > 0]$$

The conditions for taking actions can also be summarized in tabular form according to the following table 1:

## Table 1

| $\Delta g(I)$<br>$g(I)$ | $g(I) - g(I-n)$ ($\sim\frac{1}{2}$ period) | | |
|---|---|---|---|
| | $> 0$ | $= 0$ | $< 0$ |
| $g(I)>0$ | 1 Increase time between samples | 2 Increase time between samples | 3 No change |
| $g(I)=0$ | 4 Increase time between samples | 5 No change | 6 Reduce time between samples |
| $g(I)<0$ | 7 No change | 8 Reduce time between samples | 9 Reduce time between samples |

If, instead, the conditions for taking action are worded through the sampling frequency, the applying general rule will read: If the time between the samples increases, this corresponds to a reduction of the sampling frequency and vice versa. This is clear, among other things, from claim 1, where the conditions for measures to be taken have been worded starting from the sampling frequency.

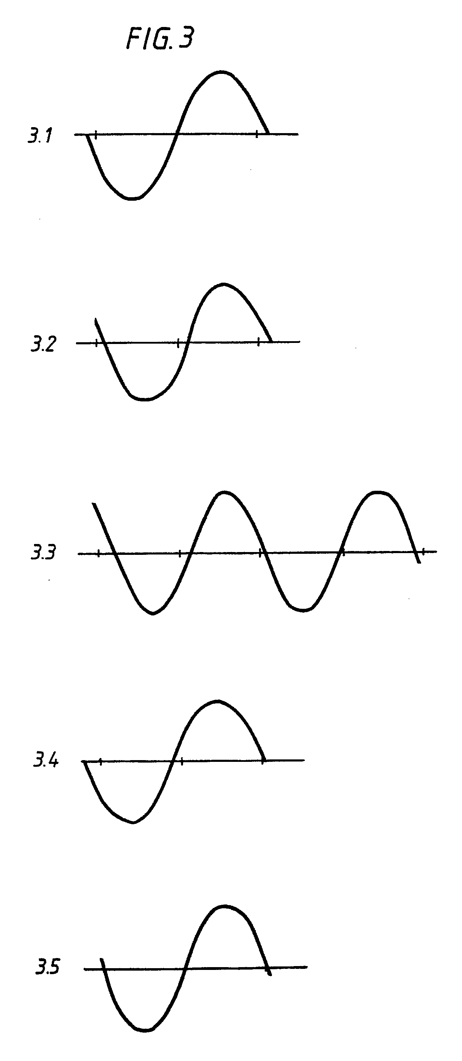

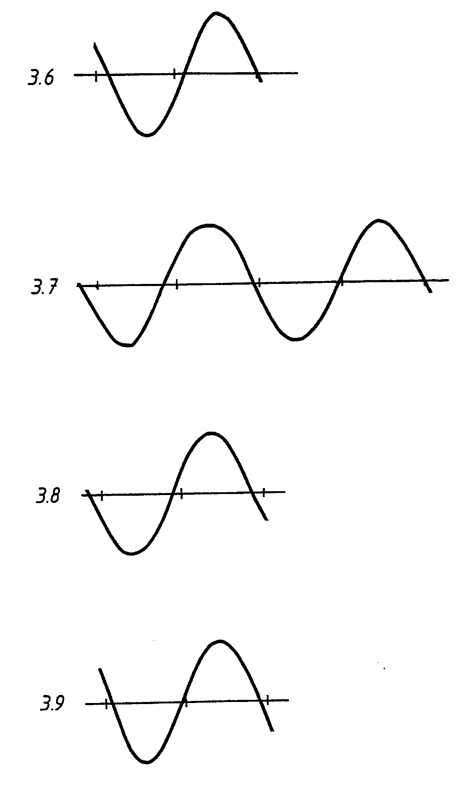

Figure 3 illustrates a number of measurements 3.1 - 3.9, corresponding to the alternatives according to the numbering occurring in table 1.

Figure 3.1 shows a measurement where the sample g(I) is positive and where the difference between samples g(I) and g(I-n) is positive. In this case, thus, we need to increase the time between the samples in order to obtain a sample as close to the zero passage as possible. After a certain increase of the time between the samples, the same sign conditions can be used also during the next measurement. This means that the time between the samples shall be further increased. Successively, some of the sign conditions will be changed, possibly so that g(I) or g(I) - g(I-n) becomes zero, which means that the time between the samples may have to be reduced or alternatively, that the time between the samples does not need to be changed.

Figure 3.5 corresponds to the case where both g(I) and g(I) - g(I-n) are zero, that is, the state towards which the system will work after having been exposed to a disturbance of some kind.

A method according to the invention is general in such a way that a zero passage from a negative to a positive value, that is, with a positive sign of the rate of change at the zero passage, can also be used for identifying the phase locking. The conditions for taking measures must then, of course, be adapted to the new conditions.

In a further method according to the invention, g(I-n) may correspond to the sample measured 1/2 period of u(t) before the sample g(I). The conditions for taking measures according to this method will be clear from table 2:

## Table 2

| $\Delta g(I)$ $\diagdown$ $g(I)$ | $g(I) - g(I-n)$ $(\sim 1/2$ period) | | |
|---|---|---|---|
| | $> 0$ | $= 0$ | $< 0$ |
| $g(I)>0$ | No change | Increase time between samples | Increase time between samples |
| $g(I)=0$ | Reduce time between samples | No change | Increase time between samples |
| $g(I)<0$ | Reduce time between samples | Reduce time between samples | No change |

The time between two samples consists of a certain number of cycle of the frequency of the oscillator in question. A change of the sampling frequency means that this number is reduced or increased by a fixed number of cycles. The magnitude of the change determines the performance of the method in such a way that a small amount of change results in a high accuracy but in reduced conformity to rapid variations of $f_m$ and vice versa.

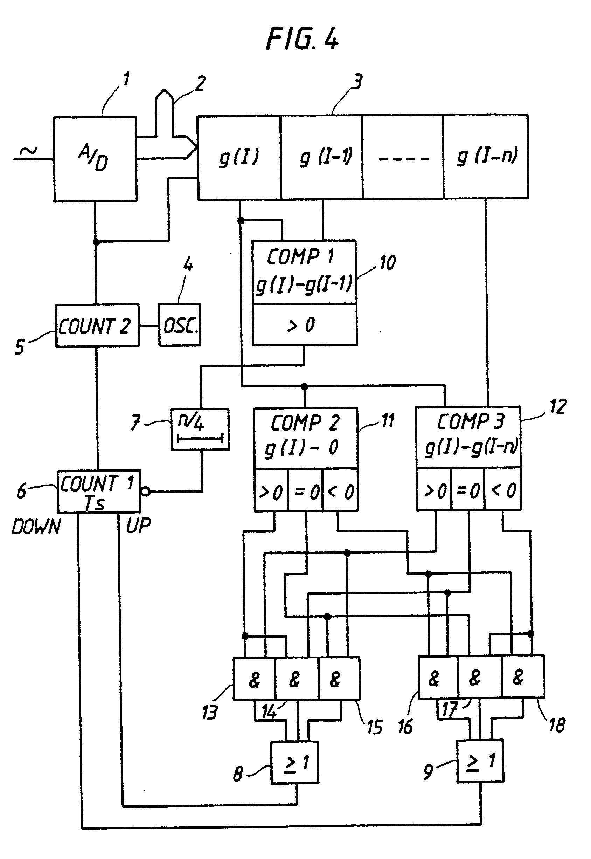

A device for carrying out the method is clear from Figure 4. The periodic quantity to be sampled is supplied to an A/D convertor 1. The sampled measured values are led in digital form, via a databus 2, to the member or members which is or are to make use of the sampled values, as well as to the device which accomplishes phase locked sampling according to the invention.

The sampled measured values are supplied to a shift register 3, in which each measured new sample is stored together with the previously stored samples, in such a way that the last $n+1$ samples are available in the shift register.

The device comprises an oscillator 4. Depending on the frequency of the oscillator and the desired number of samples per period, it is determined how many cycles of the oscillator the sampling period $T_s$ should comprise.

The counter 5 counts the number of clock pulses from the oscillator 4 until a reference value corresponding to the time $T_s$ is achieved. Thereafter, the counter is set to zero and a pulse is delivered to the A/D convertor 1 and the shift register 3. The reference value corresponding to the time $T_s$ is obtained from a count-up/count-down counter 6. The contents of the counter 6 can be changed one step at most when, and only when, a downward flank of u(t) is obtained from a time delay element 7. Whether the counter 6 counts up one step, stands still, or counts down one step is determined by the two gate elements 8 and 9. The output signals from these gate elements are such that phase locking is maintained.

The method for locating a sample which lies in the vicinity of the zero passage of the periodic quantity has been described, in principle, earlier. That part of the device according to the invention which executes the location of such a sample can be formed as is shown in Figure 4.

The value of the latest sample g(I) and the sample g(I-1) immediately before that sample in the shift register 3 is passed to a first comparator 10, which continuously compares g(I) and g(I-1) by forming the difference g(I) - g(I-1). As long as the difference is greater than zero, which also means that we are at that part of the time progress of the periodic quantity which has a positive rate of change, a "one" is obtained on the output of the comparator 10. When the difference becomes zero or changes sign, that is, when measurement is made on the peak value of the quantity or that part of the time progress of the periodic quantity having a negative rate of change, the output of the first comparatoris set to zero. This means that a signal change is obtained when approximately one quarter of the momentarily sampled period of the periodic quantity remains. Starting from n samples per period, the signal change is allowed to be passed

5

via the time delay element 7 to the counter 6 after a time which corresponds to n/4 samples later.

An embodiment of a device for carrying out the phase locking method according to the flow chart in Figure 2 can be formed as will be clear from the remaining part of Figure 4. This includes a second comparator 11 and a third comparator 12 as well as a number of AND-elements and OR-elements.

In addition to being passed to the above-mentioned first comparator 10, sample g(l) is passed also to the second comparator 11 and to the third comparator 12. To said third comparator 12, also the sample g(l-n) is passed.

In the second comparator 11 the difference g(l)-0 is formed. Depending on whether the outcome is greater than, smaller than or equal to zero, a "one" in passed from the output of the comparator to two of the AND-elements 13, 14, 15, 16, 17, 18.

In the third comparator 12 the difference g(l) - g(l-n) is formed, and in the same way a "one" is passed to two of the AND-elements 13, 14, 15, 16, 17, 18, depending on whether the outcome is greater than, smaller than, or equal to zero.

When the input signals of the AND-elements cooperate in accordance with the Boolean conditions previously described, an input signal is obtained at the OR-element 8 when the time $T_s$ between the samples shall increase, and an input signal is obtained at the OR-element 9 when the time $T_s$ shall decrease. The output signals of the OR-elements are passed to the respective inputs of the reference counter 6 to increase or decrease the number of cycles of the oscillator frequency between each sample, so as to obtain phase locking.

The device described shows a preferred embodiment of the phase locking method. In the same way as the realization of logical conditions in general can be performed in many known ways using today's technique, also the phase locking method according to this invention can be solved from a purely technical point of view in a number of different ways by the use of analog and/or hybrid analog/digital technique to a greater or lesser extent.

## Claims

1. Method for phase locked sampling during measurement of a periodic quantity u(t) with a nominal frequency $f_m$, the sampling being intended to take place n times per period of said quantity u(t) with a sampling frequency of $f_s = n \cdot f_m$, the last $n+1$ measured sampled digital values g(l), g(l-1), ..., g(l-n) being stored in a shift register (3), **characterized** in that the sampling frequency $f_s$ is increased or decreased around $f_s = n \cdot f_m$ so that it will be adapted to the periodicity of the quantity u(t) in such a way that phase locked sampling is obtained, and that the adaptation is based on the outcome of a comparison of the sampled data of g(l) and g(l-n) in such a way,

   that the sampling frequency shall be increased if g(l) is negative or zero and g(l) - g(l-n) is negative or zero, provided that g(l) and g(l) - g(l-n) are not both zero,

   that the sampling frequency shall be reduced if g(l) is positive or zero and g(l) - g(l-n) is positive or zero, provided that g(l) and g(l) - g(l-n) are not both zero, and

   that the sampling frequency need not be changed if either
   g(l) and g(l) - g(l-n) are zero, or
   g(l) is positive and g(l) - g(l-n) is negative, or
   g(l) is negative and g(l) - g(l-n) is positive.

2. Method according to claim 1, **characterized** in that the difference between the value of a sample and the value of the preceding sample is formed continuously, that the sign of the difference is sensed continuously, and that the value of the sample, which is measured n/4 samples after the change of the sign of the difference from plus to minus, is identified as g(l).

3. Method according to claim 1 or 2, **characteriz ed** in that the value of that sample which lies n samples before the value of that sample which is identified as g(l), is identified as g(l-n).

4. Device for carrying out the method according to any of the preceding claims comprising an A/D convertor (1), a databus (2), a shift register (3) with memories, an oscillator (4), a first (6) and a second

EP 0 164 710 B1

(5) counter, a time delay element (7), a first (8) and second (9) OR-element, a first (10), a second (11) and a third (12) comparator as well as a number of AND-elements (13, 14, 15, 16, 17, 18), **characterized** in that sampled digital data from said A/D convertor (1)are arranged to be supplied to the memories of the shift register (3) via said databus (2), that the sampling frequency f5 is arranged to be supplied to the shift register (3) for controlling it, that from the first two memories of the shift register (3) sampled digital data are arranged to supplied to said first comparator (10), the output of which is arranged, via said time delay element (7), to be supplied to said first counter (6), that the output signal of the first counter (6) is arranged to be supplied to said second counter (5), that the second counter (5) is also arranged to be supplied with a signal from the oscillator (4), that the output signal of the second counter (5) is arranged to be supplied to the A/D convertor (1) and the shift register (3), that digital data from the first memory of the shift register (3) are also arranged to be supplied to the second comparator (11) and third comparator (12), that digital data from the last memory of the shift register (3) is arranged to be supplied to said third comparator (12), that the output signals of the second, (11) and third (12) comparators are arranged to be supplied to a first (13), a second (14), a third (15), a fourth (16), a fifth (17) and a sixth (18) AND-element, that the output signals from the first (13), second (14) and third (15) AND-elements are arranged to be supplied to said first OR-element (8), the output signalof which is arranged to be supplied to the first counter (6), and that the output signals from the fourth(16) fifth (17) and sixth (18) AND-element are arranged to be supplied to said second OR-element (9), the output signal of which is arranged to be supplied to the first counter (6).


## Revendications

1. Procédé pour effectuer un échantillonnage avec verrouillage de phase pendant la mesure d'une quantité périodique u(t) ayant une fréquence nominale $f_m$, l'échantillonnage devant être effectué n fois par période de la quantité u(t), avec une fréquence d'échantillonnage de valeur $f_s$ = n.fm, les n + 1 dernières valeurs numériques échantillonnées et mesurées g(I-1), ..., g(I-n) étant enregistrées dans un registre à décalage (3), **caractérisé** en ce que la fréquence d'échantillonnage $f_s$ est augmentée ou diminuée de part et d'autre de $f_s$ = n.fm, de façon à être adaptée à la périodicité de la quantité u(t), de manière à obtenir l'échantillonnage avec verrouillage de phase, et en ce que l'adaptation est basée sur le résultat d'une comparaison des données échantillonnées g(I) et g(I-n) de manière que :
   la fréquence d'échantillonnage soit augmentée si la valeur g(I) est négative ou nulle et g(I) - g(I-n) est négative ou nulle, à condition que g(I) et g(I) - g(I-n) ne soient pas toutes deux nulles,
   la fréquence d'échantillonnage soit réduite si g(I) est positive ou nulle et g(I) - g(I-n) est positive ou nulle, à condition que g(I) et g(I) - g(I-n) ne soient pas toutes deux nulles, et
   la fréquence d'échantillonnage ne soit pas changée si g(I) et g(I) - g(I-n) sont égales à zéro ou si g(I) est positive et g(I) - g(I-n) est négative, ou si g(I) est négative et g(I) - g(I-n) est positive.

2. Procédé selon la revendication 1, **caractérisé** en ce que la différence entre la valeur d'un échantillon et la valeur de l'échantillon précédent est formée continuellement, en ce que le signe de la différence est détecté continuellement, et en ce qu'on prend pour g(I) la valeur de l'échantillon qui est mesurée n/4 échantillons après le changement du signe de la différence, passant de plus à moins.

3. Procédé selon la revendication 1 ou 2, **caractérisé** en ce qu'on désigne par g(I-n) la valeur de l'échantillon qui se trouve n échantillons avant la valeur d'échantillon qui est désignée par g(I).

4. Dispositif pour mettre en oeuvre le procédé selon l'une quelconque des revendications précédentes, comprenant un convertisseur A/N (1), un bus de données (2), un registre à décalage (3) avec des mémoires, un oscillateur (4), un premier compteur (6) et un second compteur (5), un élément de retard (7), un premier élément OU (8) et un second élément OU (9), un premier comparateur (10), un second comparateur (11) et un troisième comparateur (12), ainsi qu'un certain nombre d'éléments ET (13, 14, 15, 16, 17, 18), **caractérisé** en ce que des données numériques échantillonnées provenant du convertisseur A/N (1) sont appliquées aux mémoires du registre à décalage (3) par l'intermédiaire du bus de données (2), en ce que la fréquenced'échantillonnage $f_s$ est appliquée au registre à décalage (3) pour le commander, en ce que des données numériques échantillonnées provenant des deux premières mémoires du registre à décalage (3) sont appliquées au premier comparateur (10), dont le signal de sortie est appliqué, par l'intermédiaire de l'élément de retard (7), au premier compteur (6), en ce que le signal de sortie du premier compteur (6) est appliqué au second compteur (5), en ce que le second compteur (5) reçoit également un signal provenant de l'oscillateur, en ce que le signal de sortie du second compteur (5) est appliqué au convertisseur A/N (1) et au registre à décalage (3), en ce que des données numériques provenant de la première mémoire du registre à décalage (3) sont également appliquées au second comparateur (11) et au troisième comparateur (12), en ce que des données numériques provenant de la dernière mémoire du registre à décalage (3) sont appliquées au troisième comparateur (12), en ce que les signaux de sortie du second comparateur (11) et du troisième comparateur (12) sont appliqués à des premier (13), second (14), troisième (15), quatrième (16), cinquième (17) et sixième (18) éléments ET, en ce que les signaux de sortie des premier (13), second (14) et troisième (15) éléments ET sont appliqués au premier élément OU (8), dont le signal de sortie est appliqué au premier compteur (6), et en ce que les signaux de sortie des quatrième (16), cinquième (17) et sixième (18) éléments ET sont appliqués au second élément OU (9), dont le signal de sortie est appliqué au premier compteur (6).

## Ansprüche

1.  Verfahren zum phasenstarren Abtastung während der Messung einer periodischen Größe u(t) mit einer Nennfrequen $f_m$, wobei das Abtasten n Mal pro Periode der genannten Größe u(t) mit der Abtastfrequenz $f_s = nf_m$ erfolgt und die letzten n + 1 gemessenen, digitalen Abtastwerte g(l), g(l-1), ..., g(l-n) in einem Schieberegister (3) gespeichert werden, **da-durch gekennzeichnet,** daß die Abtastfrequenz $f_s$, ausgehend vom Ausgangswert fs = $nf_m$ derart vergrößert oder verkleinert wird, daß sie sich der Periodizität der Größe u(t) in solcher Weise anpaßt, daß man eine phasenstarre Abtastung erhält, und daß die Anpassung auf dem Ergebnis eines Vergleiches der abgetasteten Daten von g(l) und g(l-n) basierend in solcher Weise geschieht,

    daß die Abtastfrequenz vergrößert wird, wenn g(l) negativ oder Null ist und g(l) - g(l-n) negativ oder Null ist, vorausgesetzt daß g(l) und g(l) - g(l-n) nicht gleichzeitig Null sind,

    daß die Abtastfrequenz verkleinert wird, wenn g(l) positiv oder Null ist und g(l) - g(l-n) positiv oder Null ist, vorausgesetzt daß g(l) und g(l) - g(l-n) nicht gleichzeitig Null sind, und

    daß die Abtastfrequenz nicht geändert zu werden braucht, wenn entweder
    g(l) und g(l) - g(l-n) Null sind, oder
    g(l) positiv ist und g(l) - g(l-n) negativ ist, oder
    g(l) negativ ist und g(l) - g(l-n) positiv ist.

2.  Verfahren nach Anspruch (1), **dadurch gekennzeichnet,** daß die Differenz zwischen einem Abtastwert und dem Wert der vorangegangenen Abtastung kontinuierlichgebildet wird, daß das Vorzeichen der Differenz kontinuierlich erfaßt wird und daß der Wert der Abtastung, welcher n/4 Abtastungen nach dem Wechsel des Vorzeichens der Differenz von plus nach minus gemessen wird, als g(l) definiert wird.

3.  Verfahren nach Anspruch 1 oder 2, **dadurch gekennzeichnet,** daß der Wert derjenigen Abtastung, die n Abtastungen vor dem Wert der Abtastung liegt, die als g(l) definiert wurde, als g(l-n) definiert wird.

4.  Vorrichtung zur Durchführung des Verfahrens nach einem der vorhergehenden Ansprüche mit einem A/D-Wandler (1), einem Datenbus (2), einem Schieberegister (3) mit Speichern, einem Oszillator (4), einem ersten (6) und einem zweiten (5) Zähler, einem Zeitverzögerungsglied (7), einem ersten (8) und einem zweiten (9) ODER-Glied, einem ersten (10), einem zweiten (11) und einem dritten (12) Vergleicher, sowie einer Anzahl von UND-Gliedern (13, 14, 15, 16, 17, 18), **dadurch gekennzeichnet,** daß die Vorrichtung so aufgebaut ist, daß abgetastete, digitale Daten von dem genannten A/D-Wandler (1) über den Datenbus (2) zu den Speichern des Schieberegisters (3) überragen werden können, daß die Abtastfrequenz $f_s$ zur Steuerung des Schieberegisters (3) dient, daß von den ersten beiden Speichern des Schieberegisters (3) abgetastete, digitale Daten zu dem genannten ersten Vergleicher (10) übertragen werden können, deren Ausgangssignale über das genannte Zeitverzögerungsglied (7) an den ersten Zähler (6) übertragen werden können, daß das Ausgangssignal des ersten Zählers (6) an den zweiten Zähler (5) übertragen werden kann, daß dem zweiten Zähler (5) auch ein Signal vom Oszillator (4) zugeführt werden kann, daß das Ausgangssignal des zweiten Zählers (5) an den A/D-Wandler (1) und an das Schieberegister (3) übertragen werden kann, daß digitale Daten von dem ersten Speicher des Schieberegisters (3) auch dem zweiten Vergleicher (11) und dem dritten Vergleicher (12) zugeführt werden können, daß digitale Daten von dem letzten Speicher des Schieberegisters (3) dem genannten dritten Vergleicher (12) zugeführt werden können, daß die Ausgangssignale des zweiten (11) und des dritten (12) Vergleichers an ein erstes (13), ein zweites (14), ein drittes (15), ein viertes (16), ein fünftes (17), und ein sechstes (18) UND-Glied übertragen werden können, daß die Ausgangssignale des ersten (13), zweiten (14), und dritten (15) UND-Gliedes an das erste ODER-Glied (8) übertragen werden kann, dessen Ausgangssignal an den ersten Zähler (6) übertragen werden kann, und daß die Ausgangssignale des vierten (16), fünften (17) und sechsten (18) UND-Gliedes an das genannte zweite ODER-Glied (9) übertragen werden können, dessen Ausgangssignal an den ersten Zähler (6)übertragen werden kann.

FIG.1

FIG.2

## FIG. 3

3.6

3.7

3.8

3.9

# FIG. 4